# EUROPEAN PATENT SPECIFICATION

(11) **EP 1 542 363 B1**
(45) Date of publication and mention of the grant of the patent: **04.04.2007**
(21) Application number: 02770004.6
(22) Date of filing: 10.09.2002
(51) Int. Cl.: H03K 17/96, H01H 13/70

(54) **KEYPAD FOR VENDING MACHINES**
TASTENFELD FÜR VERKAUFSMASCHINEN
CLAVIER DE DISTRIBUTEUR AUTOMATIQUE

(43) Date of publication of application: 15.06.2005
(73) Proprietor: AZKOYEN INDUSTRIAL, S.A., 31350 Peralta (Pamplona) (ES)
(72) Inventor: ARCELUS LECUMBERRI, Lorenzo, E-31350 Peralta (Pamplona) (ES)
(74) Representative: Carpintero Lopez, Francisco
(86) International application number: PCT/ES2002/000424
(87) International publication number: WO 2004/025835

(56) References cited:
- US-A- 4 218 603
- US-A- 4 334 219
- US-A- 4 377 049
- US-A- 5 239 152
- US-A- 5 917 165

## Description

### OBJECT OF THE INVENTION

This invention refers to a keyboard for product sale machines, herein after denominated "vending" machines, that incorporate a series of keys or push buttons whose manual operation brings about the activation of the corresponding mechanisms by means of which the product selected, that is the one shown on the key or push button that has been activated, is dispensed.

The object of the invention is to provide a keyboard for the above-mentioned type of machines, that is based on an array of proximity sensors in which the emitter and receiver of each sensor are formed by laminae of translucent film electrically connected to a printed circuit with the electronic components that allow the presence of the user's finger to be detected, all of this in such a way that by means of a lighting source placed behind the printed circuit opportune lighting of the panel front is provided, the keyboard being seen from outside.

### BACKGROUND OF THE INVENTION

Vending machines dispense articles or products such as cans of drink, edible products, etc, in such a way that they can operate alone and without the need for an operator, being exposed to users who sometimes carry out acts of vandalism on the actual machine, including attempts at fraud and theft, more or less sophisticated, likewise spillages of liquids being produced due to incorrect use or acts of hooliganism that causes the corresponding dirtiness of the keyboards or push buttons.

This type of machine must incorporate direct publicity of the product that is on sale, because of which they must be attractive visually and with good illumination of the logos or labels of the products on sale.

Similarly, it is of interest that the keyboards can be especially configured for special clients (large distributors), changing the number and size of the keys without having to make significant investments in manufacturing tools, specifically in dyes or moulds.

The fundamental problems that this type of machine present concerns the product selection keys, as well as information screens for price, credit, etc., various solutions to lessen or to resolve these difficulties existing.

Specifically, vending machines have a number of electromechanical keyboards that can consist of push buttons soldered to a printed circuit, or using silicone keys that close contacts in a printed circuit; even using membrane keyboards.

When push buttons soldered to a printed circuit are used, an external button that presses the push button is necessary, which obligates investments in moulds of plastic parts that cannot be easily modified, problems of watertightness and of dirt in the key slots also existing.

The use of silicone keys, although it implies a very economic solution, also presents disadvantages such as those previously referred to.

The use of membrane keyboards presents certain advantages such as their optimum watertightness and ease of cleaning, although they have the disadvantage in that they have little resistant to acts of vandalism, being easily burnt or torn.

On the other hand, in electrical appliances, specifically in vitroceramics, keyboards are known with proximity sensors in each key, and whose sensors can be infrared light reflection or electric field alteration sensors, in this latter case also called capacitive.

The advantages of the sensors of electric field alteration sensors are known, although these advantages are valid for the type of electrical appliance previously referred to, whereas their application in vending machines presents several limitations or disadvantages among which it is possible to mention the following:
- The maximum thickness of the panel through which a finger is detectable is very small, because of which the range of detection is reduced.
- When a change of the environmental conditions of temperature and moisture occurs, the reading changes, with the problems and disadvantages that this implies.
- In certain cases the reading in some types of sensors is affected by the earthing of the machine, and by the insulation between the user and the electrical earth (floors and insulating shoes diminish the effectiveness of the sensor).
- Illumination from behind the products and prices labels is not possible.

The patent US-5.239.152 refers to a touch sensor panel with hidden graphic mode, which is not related to the claimed subject-matter.

### DESCRIPTION OF THE INVENTION

The present invention refers to a vending machine keyboard as defined in the attached independent claim.

The keyboard that is proposed has been planned to resolve the difficulties previously set out, being applicable with total efficacy in vending machines, which is the purpose for which the keyboard in question has been envisaged.

More specifically, the keyboard of the invention, being based on the detection of the alteration in electrical field produced by the human body, being of capacitive type operation, has an array of proximity sensors, one for each function or key provided in the machine; each sensor incorporating a number of laminae of conductive translucent film, that remain positioned behind the transparent glass or plastic front of the machine and connecting with a printed circuit placed behind; wherein the printed circuit supports the corresponding electronic components for the correct operation of the assembly.

The electronic components form a circuit especially designed to obtain high sensitivity of detection and auto-calibration of the system that makes it immune to changes in conditions.

The keyboard will furthermore be complemented with sources of illumination placed behind the printed circuit, that pass through the laminae of translucent film, being seen from beyond the keyboard; openings in the corresponding printed circuit being envisaged for this purpose, in order that through them the light emitted by these sources of illumination can pass, and reach the front part through the laminae of translucent film, or, what is the same, the frontally provided transparent panel, that will be of great thickness to provide good protection from external factors and effects of vandalism.

Each one of the proximity sensors positioned in the sensor array will have the actual measurement of the standard labels used in vending machines, to show the products on sale, so that the user makes the selection by placing a finger on the panel, specifically in the area of the product label, although keys of very diverse shapes and sizes, with the same basic structure, can be provided.

In any case, the laminae forming the emitter and receiver of each sensor could be included in the actual printed circuit that, in this case, would not have openings, since the light emitted by the sources of illumination would directly fall on the emitter and receiver laminae.

Also several sensors of the array could work together, by means of programming, thus acting as a single element. This would, for example, allow keyboards of labels of different dimensions with the same physical backing to be produced.

The electronic circuit for detection or finger presence is formed by a microprocessor connected to a number of resistances, amplifiers and comparer, in parallel with a reference capacitor; in such a way that this detection circuit treats the emitter and receiver that comprise the sensor as a capacitor of variable capacitance, so that the variation of said capacitance will be established when the dielectric that surrounds it is changed, as happens when a finger is brought close to an element that modifies the electric field.

### DESCRIPTION OF THE DRAWINGS

To supplement this description and with the aim of leading to a better understanding of the characteristics of the invention, in accordance with a preferred example of its practical embodiment, as an integral part of this description it is accompanied by a set of drawings where in an illustrative and non-limiting way, the following have been represented:
Figure 1.- Shows a schematic section view of the front panel in which the array of proximity sensors, object of the invention, is established.
Figure 2. - Shows an enlarged section view of the embodiment of a proximity sensor, carried out in agreement with the object of this invention.
Figure 3.- Shows, finally, the schematic diagram corresponding to the electronic circuit for detection of proximity of a finger.

### PREFERABLE EMBODIMENT OF THE INVENTION

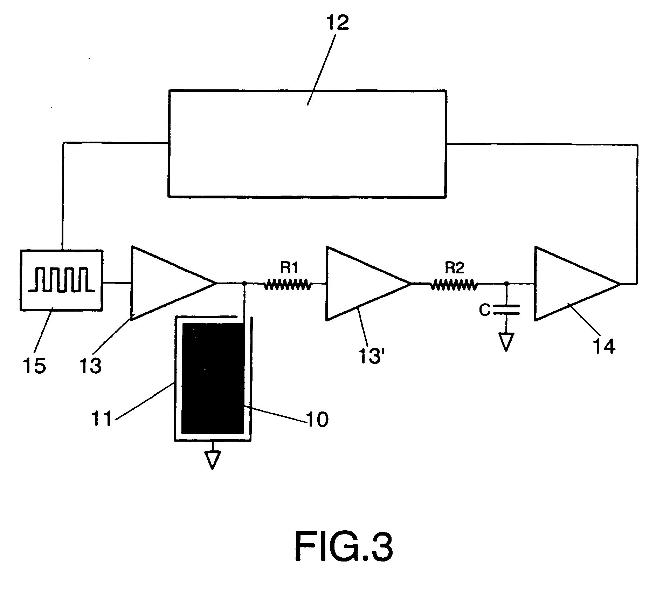

In view of the figures depicted it can be observed how the keyboard for vending machines, subject of the invention, has an array of proximity sensors that will detect the variation in the electrical field caused by bringing a finger near to the corresponding front transparent panel (1), that is of significant thickness, behind which the product labels (2) and price (2') labels are placed, and behind these a translucent film (3) forming the emitter and receiver, on a printed circuit (4) which supports the electronic components, and the detection circuit between the transparent panel (1) and printed circuit (4), as shown in figure 3.

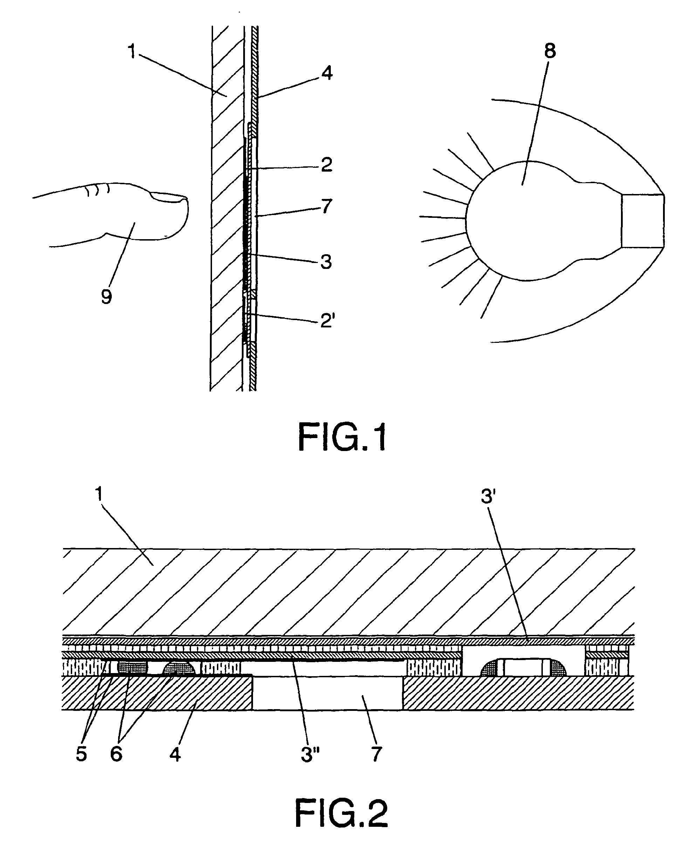

In the specific form shown in figure 2 it can be seen what would be the made-up of a proximity sensor, placed behind the thick translucent front panel (1), where the emitter and receiver are formed by the translucent laminae (3') and (3") whose measurements will correspond with those of the product label used in this type of vending machine, labels (2) and (2') that will remain positioned between these laminae or films of translucent material (3'-3") and the back side of the thick front panel (1).

The aforementioned laminae or film (3'-3"), which are conductive, are electrically connected to the printed circuit (4), through conductive zones (5) and portions of conductive glue (6), as is shown in figure 2.

The printed circuit (4) has openings (7) to allow light emitted by a source of illumination (8) to pass through, as is shown in figure 1, so that it can illuminate the front part of the sensor through the laminae or translucent film (3'-3"), or in other words, the frontally positioned labels (2) and (2').

The circuit for detection of presence of a finger (9) near to the front panel (1), is that shown in figure 3; a circuit that treats the emitter and receiver formed by the films or translucent laminae (3'-3") which form the actual sensor, as a capacitor of variable capacitance referenced (10) in this figure 3, which is formed by a conductive area surrounded by a loop (11) also conductive, in such a way that the dimensions of this sensor can correspond with those of the standard label of vending machines, although sensors of different sizes and shapes can be made.

In any case, the capacity of this capacitor (10) varies as the surrounding dielectric is changed, as happens when a finger or any element that modifies the electric field is brought close; measurement of the capacity being established by the circuit shown in figure 3, which has a microprocessor (12), a pair of amplifiers (13) and (13'), a comparer (14), as well as the resistances (R1, R2) and reference capacitor (C), all of this so that the sensor (10) is charged by each impulse (15) that it receives, subsequently discharging after through the resistance (R1).

While the discharge of the sensor (10) through the resistance (R1) continues, the reference capacitor (C) is charged, through the resistance (R2), in such a way that the charging time of this capacitor (C) in each impulse will depend on the capacity of the sensor (10).

On bringing a finger (9) close to the sensor the capacity of this latter increases and the capacitor (C) charging times are longer, reaching the level of charge programmed with a number of smaller pulses.

The pulses (15) are sent to the sensor (10) from the microprocessor (12), in such a way that as the pulses are received the capacitor (C) is charged, as has been previously said, until a voltage level set in the comparer (14) is reached, the signal obtained being received in the microprocessor (12), all this in a such way that the number of pulses sent by this latter, until obtaining the "capacitor charged" signal, is the data that allows the approach of the finger to the sensor to be accurately detected.

The number of pulses sent to each sensor, until the signal of the comparer (14) is received, later undergoes mathematical processing that allows the variations resulting between the last reading and an arithmetical weighted average of the previous readings, and whose weighted average is constantly changing, slowly adapting to system changes due to variations in temperature, humidity, changes of labels, etc., therefore it being possible to consider that the system auto-calibrates; automatically compensating for the changes after a given time.

Finally, to state that the adaptation is carried out at different speed when the signal received increases or decreases, so that the change produced by leaving a finger resting on a key or sensor is compensated more slowly than the change produced by withdrawing the finger, which has importance since it combines maximum sensitivity with the resulting adaptation time.

Among the advantages and improvements that the keyboard described entails, the following can be mentioned as the more important:
1.- A keyboard with no physical contact is obtained, and therefore without wear of moveable pieces or electrical contacts.
2.- Ease of cleaning of the front panel, since it is an obstacle-free smooth panel of glass or transparent methacrylate.
3.- Resistance of the system against vandalism, since the only accessible element is the front panel and this is thick and resistant.
4.- Versatility in changing key size distributions without the need to modify either moulds or dyes, it being necessary only to design a printed new circuit.
5.- Possibility of illuminating the keyboard and the corresponding products or prices labels associated with the push buttons, from the rear section, by virtue of the transparency of the translucent elements that form the film or conductive laminae that form the sensor emitter and receiver.
6.- Reliable readings, by virtue of which capture is insensitive to environmental conditions of temperature and humidity, as a consequence of the special make-up of the detection circuit.

## Claims

1. - Vending machine keyboard, **characterised in that** it has an array of capacitive proximity sensors, each of which consists of a pair of translucent laminae (3'-3") forming the emitter and receiver of the respective sensor; wherein said laminae (3'-3 ") connected to a printed circuit (4) placed adjacent to the back surface of a transparent front panel (1), and wherein product labels (2) and price (2') labels are placed between said transparent front panel (1) and said laminae (3'-3"); and wherein the printed circuit (4) has openings (7) to allow light emitted by sources of illumination (8) placed behind said printed circuit (4) to pass through the translucent laminae (3'-3") and illuminating the keyboard front.

2. Vending machine keyboard, according to claim 1, **characterised in that** the translucent laminae (3'-3") forming the emitter and receiver of each sensor are electrically connected to the printed circuit (4) through conductive zones (5) and portions of conductive glue (6).

3. Vending machine keyboard, according to claim 1, **characterised in that** the laminae (3'-3"), forming the emitter and receiver of each sensor, are part of the printed circuit (4), that in this region has no openings (7).

4. Vending machine keyboard, according to claim 1, **characterised in that** several sensors of the array function together by means of a program, acting as if it were a single element, thus allowing keyboards of labels of different dimensions with the same physical support to be produced.

5. Vending machine keyboard, according to previous claims, **characterised in that** the printed circuit (4) has an electronic circuit for detection of the proximity of a finger (9) by means of which each sensor is activated, said electronic circuit having a microprocessor (12), a pair of amplifiers (13) and (13'), a discharge resistance (R1) and a charge resistance (R2), of a reference capacitor (C) connected between said resistance (R2) and a comparer (14) that is connected to the microprocessor (12); in such a way that the pulses (15) that are sent to the corresponding sensor (10) connected to the electronic circuit, produce the charging of the reference capacitor (C) to a voltage level fixed by the comparer (14); the signal obtained being received in the microprocessor (12), which sends pulses until obtaining the "capacitor charged" signal, which data allows the nearing of a finger (9) to the sensor (10) to be accurately detected.

## Patentansprüche

1. Tastenfeld für Verkaufsmaschinen, **dadurch gekennzeichnet, dass** es eine Anordnung von kapazitiven Näherungssensoren hat, von denen jeder aus einem Paar lichtdurchlässiger Platten (3'-3") besteht, die den Sender und Empfänger des entsprechenden Sensors bilden; wobei die Platten (3'-3") mit einer gedruckten Schaltung (4) verbunden sind, die benachbart zu der rückwärtigen Oberfläche einer transparenten Frontblende (1) angeordnet ist, und wobei Produktlabel (2) und Preislabel (2') zwischen der transparenten Frontblende (1) und den Platten (3'-3") angeordnet sind; und wobei die gedruckte Schaltung (4) Öffnungen (7) hat, damit Licht, das von hinter der gedruckten Schaltung (4) angeordneten Beleuchtungsquellen (8) ausgesandt wurde, durch die lichtdurchlässigen Platten (3'-3") hindurch gelangt und die Vorderseite des Tastenfeldes beleuchtet.

2. Tastenfeld für Verkaufsmaschinen nach Anspruch 1, **dadurch gekennzeichnet, dass** die lichtdurchlässigen Platten (3'-3"), die den Sender und Empfänger jedes Sensors bilden, elektrisch mit der gedruckten Schaltung (4) mittels leitfähigen Bereichen (5) und Abschnitten mit leitfähigem Kleber (6) verbunden sind.

3. Tastenfeld für Verkaufsmaschinen nach Anspruch 1, **dadurch gekennzeichnet, dass** die Platten (3'-3"), die den Sender und Empfänger jedes Sensors bilden, Teil der gedruckten Schaltung (4) sind, die in diesem Bereich keine Öffnungen (7) hat.

4. Tastenfeld für Verkaufsmaschinen nach Anspruch 1, **dadurch gekennzeichnet, dass** mehrere Sensoren der Anordnung mittels eines Programms zusammenwirken, das so arbeitet, als wären diese ein einzelnes Element, wodurch Tastenfelder mit Labeln unterschiedlicher Abmessungen mit demselben physikalischen Träger hergestellt werden können.

5. Tastenfeld für Verkaufsmaschinen nach einem der vorangehenden Ansprüche, **dadurch gekennzeichnet, dass** die gedruckte Schaltung (4) eine elektronische Schaltung zur Erkennung der Nähe eines Fingers (9) hat, durch die jeder Sensors aktiviert wird, wobei die elektronische Schaltung einen Mikroprozessor (12), ein Paar von Verstärkern (13,13'), einen Entladewiderstand (R1) und einen Ladewiderstand (R2), und einen Referenzkondensator (C) hat, der zwischen dem Widerstand (R2) und einem Vergleicher (14) angeschlossen ist, der mit dem Mikroprozessor (12) verbunden ist; derart, dass die Impulse (15), die zu dem mit der elektronischen Schaltung verbundenen entsprechenden Sensor (10) gesendet werden, das Laden des Referenzkondensators (C) zu einem Spannungspegel bewirken, der durch den Vergleicher (14) festgelegt ist; wobei das erhaltene Signal im Mikroprozessor (12) empfangen wird, der bis zum Erhalten des Signals "Kondensator geladen" Impulse sendet, welche Daten ermöglichen, das Annähern eines Fingers (9) an den Sensor (10) genau zu bestimmen.

## Revendications

1. Clavier de machine distributrice, **caractérisé en ce qu'**il présente une matrice de capteurs de proximité capacitifs, chacun des capteurs consistant en une paire de feuilles translucides (3'-3") formant l'émetteur et le récepteur du capteur réceptif; lesdites feuilles (3'-3") étant connectées à un circuit imprimé (4) et disposées adjacentes à la surface arrière d'un panneau avant transparent (1), et des étiquettes de produit (2) et des étiquettes de prix (2') étant disposées entre ledit panneau avant transparent (1) et lesdites feuilles (3'-3") ; et le circuit imprimé (4) présentant des ouvertures (7) pour permettre à la lumière émise par des sources de lumière (8) disposées derrière ledit circuit imprimé (4) de passer à travers les feuilles translucides (3'-3") et d'illuminer l'avant du clavier.

2. Clavier de machine distributrice, selon la revendication 1, **caractérisé en ce que** les feuilles translucides (3'-3") formant l'émetteur et le récepteur de chaque capteur sont connectées électriquement au circuit imprimé (4) par l'intermédiaire de zones conductrices (5) et de portions de colle conductrice (6).

3. Clavier de machine distributrice, selon la revendication 1, **caractérisé en ce que** les feuilles (3'-3"), formant l'émetteur et le récepteur de chaque capteur, font partie du circuit imprimé (4), qui dans cette région n'a pas d'ouvertures.

4. Clavier de machine distributrice selon la revendication 1, **caractérisé en ce que** plusieurs capteurs de la matrice fonctionnent ensemble au moyen d'un programme, agissant comme s'il y avait un unique élément, et permettant ainsi à des claviers d'étiquettes de différentes dimensions avec le même support physique d'être produits.

5. Clavier de machine distributrice, selon des revendications précédentes, **caractérisé en ce que** le circuit imprimé (4) présente un circuit électronique pour détecter la proximité d'un doigt (9) au moyen duquel chaque capteur est activé, ledit circuit électronique présentant un microprocesseur (12), une paire d'amplificateurs (13) et 13'), une résistance de décharge (R1) et une résistance de charge (R2), d'un condensateur de référence (C) connecté entre ladite résistance (R2) et un comparateur (14) qui est connecté au microprocesseur (12) ; de telle sorte que les impulsions (15) qui sont envoyées au capteur correspondant (10) connecté au circuit électronique, produisent la charge du condensateur de référence (C) jusqu'à un niveau de tension fixe par le comparateur (14) ; le signal obtenu étant reçu dans le microprocesseur (12), qui envoie des impulsions jusqu'à obtenir le signal "condensateur chargé", lesquelles données permettent de détecter de façon exacte l'approche d'un doigt (9) vers le capteur (10).
